# EUROPEAN PATENT SPECIFICATION

(11) **EP 1 545 044 B1**
(45) Date of publication and mention of the grant of the patent: **30.03.2011**
(21) Application number: 04026612.4
(22) Date of filing: 09.11.2004
(51) Int. Cl.: H04L 7/02, H04L 25/03

(54) **Decision feedback equalizer and clock and data recovery circuit for high-speed applications**
Entscheidungsrückgekoppelte Entzerrer und Takt- und Daten-Rückgewinnungsschaltung für Hochgeschwindigkeitsanwendungen
Egaliseur à retour de décisions et circuit de récupération d'horloge et de données pour des applications à haute vitesse

(30) Priority: 19.12.2003 US 531403 P; 19.12.2003 US 531094 P; 19.12.2003 US 530968 P; 19.12.2003 US 531402 P; 09.02.2004 US 774965
(43) Date of publication of application: 22.06.2005
(73) Proprietor: Broadcom Corporation, Irvine, CA 92617 (US)
(72) Inventor: Buer, Mark, Gilbert, AZ 85296 (US); Frank, Edward H., Atherton, CA 94027 (US); Seshadri, Nambirajan, Irvine, CA 92612 (US)
(74) Representative: Jehle, Volker Armin

(56) References cited:
- WO-A-2004/002023
- US-A1- 2004 258 145
- US-B1- 6 556 637

## Description

### BACKGROUND

Many high speed serial communication systems only transmit data over the communication media. In other words, these systems do not transmit clock signals that may be used by a receiver to recover the data. Consequently, receivers for high speed serial communication systems typically include clock and data recovery circuits that produce a clock signal synchronized with the incoming data that is then used to recover the data. Data is typically recovered by generating a clock signal at a frequency that matches the frequency of an incoming data stream. The clock is then used to sample or recover the individual data bits.

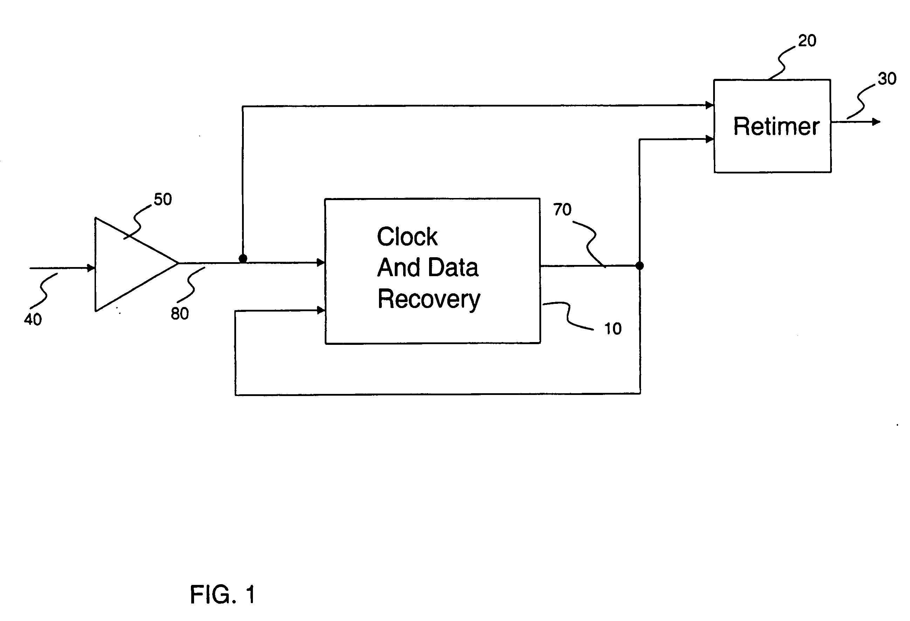

For example, FIG. 1 illustrates a typical receiver that utilizes a clock and data recovery circuit 10 and retimer 20 to generate recovered data 30. Typically incoming data 40 is amplified by one or more buffer stages 50 and the clock and data recovery circuit 10 generates an extracted clock signal 70 that has a phase and/or frequency that is fixed relative to the phase and/or frequency of the incoming amplified data 80.

The clock and data recovery circuit 10 may comprise a phase lock loop or delay lock loop that aligns the edges of the extracted clock, for example the rising edge, with the transition edge of the incoming data. In this instance the falling edge of the clock is approximately in the middle of the incoming data symbol. In this instance the retimer 20 may comprise, by way of example, a falling edge flip flop that is triggered to recover the transmitted data on the falling edge of the clock.

In operation however, bandwidth limitations inherent in many communication media tend to create increasing levels of data distortion with increasing data rate and channel length. For example, band-limited channels tend to spread transmitted pulses. If the width of the spread pulse exceeds a symbol duration, overlap with neighboring pulses may occur, degrading the performance of the receiver. Therefore, typical high speed receivers may also include an adaptive equalizer, such as, for example, a decision feedback equalizer that cancels or reduces inter-symbol interference caused by micro-reflections in the channel.

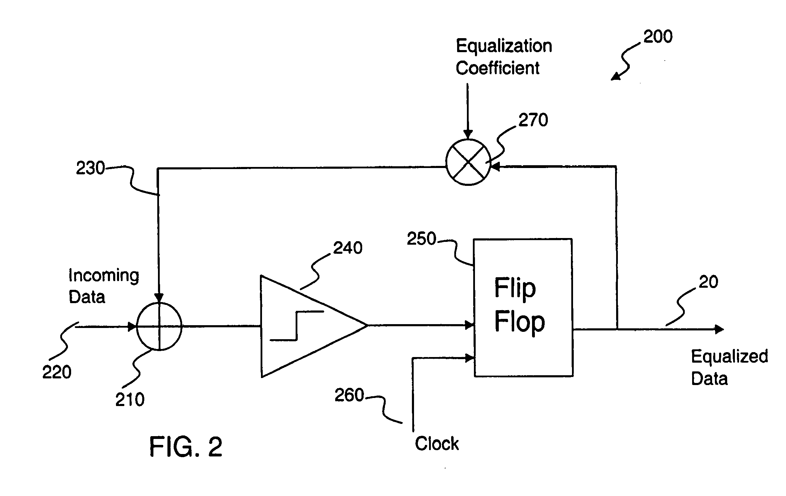

For example, FIG. 2 is a simplified block diagram of a conventional one tap decision feedback equalizer 200 where a summer 210 combines the incoming data 220 with a feedback signal 230. A slicer 240 converts the output of the summer (soft decision) to a binary signal. A flip flop 250 recovers the data from the binary signal in response to a clock 260. A multiplier 270 scales the recovered data by an equalization coefficient (g1) to generate the feedback signal 230 (typically a negative number) that is then combined with incoming data. The equalizer therefore serves to subtract a previous symbol from a current symbol to reduce or eliminate channel induced distortion such as inter-symbol interference.

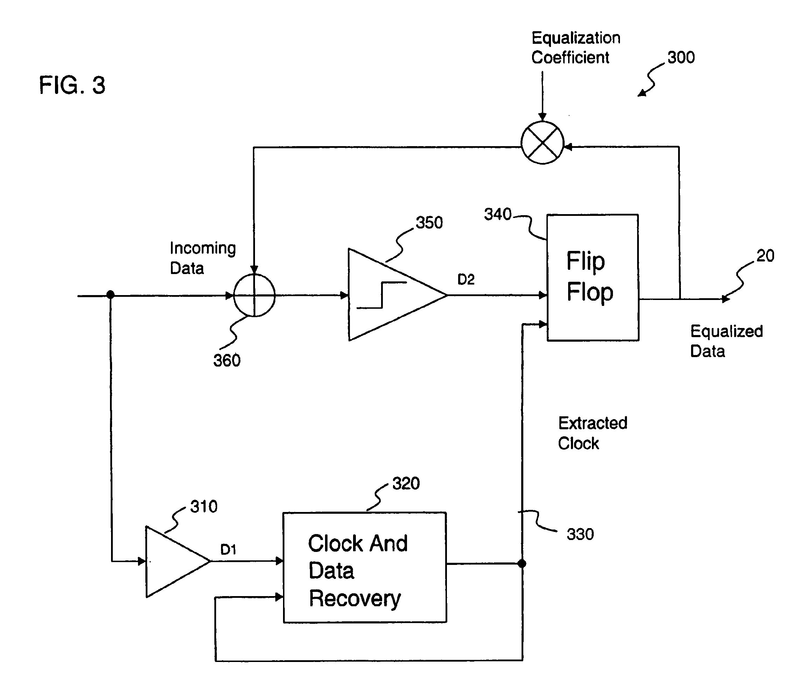

In conventional receivers the extracted clock from the clock and data recovery circuit drives the flip flop to recover equalized data. For example, FIG. 3 is a simplified block diagram of a decision feedback equalizer and clock and data recovery circuit based receiver 300. In this receiver incoming data is again amplified by one or more buffer stages 310. The clock and data recovery circuit 320 generates an extracted clock 330 from the amplified data (D1) and drives the decision feedback equalizer flip flop 340 that recovers the equalized (D2) data provided by slicer 350.

In the illustrated receiver the clock and data recovery circuit 320 aligns the rising edge of the extracted clock 330 with the transition edge of the amplified data D1. In practice, however, the rising edge of the extracted clock 330 should be aligned with the equalized data (D2) output by the slicer 350 for proper data recovery by flip flop 340. Therefore, the time delay through summer 360 and slicer 350 should be equal to the time delay through buffer stage(s) 310 to ensure that the input data (D2) and clock signal 330 of flip flop 340 are aligned to properly recover the equalizer data.

Accordingly, conventional receivers typically include delay matching stages (not shown) to adjust the delay through the buffer stage(s) 310 to match the delay through summer 360 and slicer 350 to align the binary signal (D2) and extracted clock signal 330. In practice, however, process variations and performance variations over temperature may make it difficult to match the delay through the buffer stage(s) with the delay through the summer and slicer, thereby limiting the performance of conventional receivers.

Further, when inter-symbol interference is relatively large the clock and data recovery circuit may no longer properly track the transition edges of the incoming data. In these instances the extracted clock signal 330 is no longer locked to or synchronized with the incoming data stream and the recovered equalized data may be corrupted. Therefore conventional receivers often have limited tolerance to inter-symbol interference. US 6,556,637 B1 discloses a receiver using signal replicas to improve the locking behavior of its timing recovery circuit.

### SUMMARY

The invention is defined as set forth in the claims. In one example a communications system includes an equalizer adapted to reduce channel related distortion in received data and a clock and data recovery circuit coupled to the equalizer. In this example the clock and data recovery circuit generates an extracted clock signal from the equalized data and an equalizer retimer generates recovered equalized data from the equalized data in response to the extracted clock signal.
According to an example, a communications system comprises:
a decision feedback equalizer adapted to reduce channel related distortion in received data, wherein the decision feedback equalizer generates equalized data; and
a clock and data recovery circuit coupled to the decision feedback equalizer, wherein the clock and data recovery circuit generates an extracted clock signal from the equalized data and wherein the decision feedback equalizer includes a retimer that generates recovered equalized data from the equalized data in response to the extracted clock signal.

Advantageously, the decision feedback equalizer comprises a summer that generates a combined signal by combining an equalized feedback signal with the received data to reduce the channel related distortion.

Advantageously, the decision feedback equalizer further comprises a slicer coupled to the summer, wherein the slicer generates the equalized data by converting the combined signal into a binary signal and wherein the clock and data recovery circuit generates the extracted clock signal from the binary signal.

Advantageously, the retimer comprises a flip flop coupled to the slicer and the clock and data recovery circuit and wherein the flip flop generates recovered equalized data from the binary signal in response to the extracted clock signal.

Advantageously, the clock and data recovery circuit comprises a frequency acquisition loop and a phase lock loop, wherein the frequency acquisition loop adjusts frequency of the extracted clock signal to maintain a fixed relationship between frequency of the binary signal and the frequency of the extracted clock signal and wherein the phase lock loop adjusts phase of the extracted clock signal to maintain a fixed relationship between phase of the binary signal and the phase of the extracted clock signal.

Advantageously, the clock and data recovery circuit further comprises a frequency lock detector for determining when the frequency of the extracted clock signal is fixed relative to the frequency of the binary signal.

Advantageously, the decision feedback equalizer further comprises a multiplier coupled to the retimer and wherein the multiplier applies an equalization coefficient to the recovered equalized data to generate the equalized feedback signal.

Advantageously, the multiplier applies a predetermined equalization coefficient upon start up.

According to an example, a communication system comprises:
a transmitter transmitting an information signal over a communication media; and
a receiver coupled to the communication media for receiving the transmitted information signal, wherein the receiver comprises:
   a decision feedback equalizer adapted to reduce channel related distortion in received data, wherein the decision feedback equalizer generates equalized data, and
   a clock and data recovery circuit coupled to the decision feedback equalizer, wherein the clock and data recovery circuit generates an extracted clock signal from the equalized data and wherein the decision feedback equalizer includes a retimer that generates recovered equalized data from the equalized data in response to the extracted clock signal.

Advantageously, the decision feedback equalizer comprises a summer that generates a combined signal by combining an equalized feedback signal with the received data to reduce the channel related distortion.

Advantageously, the decision feedback equalizer further comprises a slicer coupled to the summer, wherein the slicer generates the equalized data by converting the combined signal into a binary signal and wherein the clock and data recovery circuit generates the extracted clock signal from the binary signal.

Advantageously, the retimer comprises a flip flop coupled to the slicer and the clock and data recovery circuit and wherein the flip flop generates recovered equalized data from the binary signal in response to the extracted clock signal.

Advantageously, the clock and data recovery circuit comprises a frequency acquisition loop and a phase lock loop, wherein the frequency acquisition loop adjusts frequency of the extracted clock signal to maintain a fixed relationship between frequency of the binary signal and the frequency of the extracted clock signal and wherein the phase lock loop adjusts phase of the extracted clock signal to maintain a fixed relationship between phase of the binary signal and the phase of the extracted clock signal.

Advantageously, the clock and data recovery circuit further comprises a frequency lock detector for determining when the frequency of the extracted clock signal is fixed relative to the frequency of the binary signal.

Advantageously, the equalizer further comprises a multiplier coupled to the retimer and wherein the equalizer applies an equalization coefficient to the recovered equalized data to generate the equalized feedback signal.

Advantageously, the multiplier applies a predetermined equalization coefficient upon start up.

According to an example, a communications system comprises:
a decision feedback equalizer adapted to reduce channel related distortion in received data, the decision feedback equalizer comprising:
   a summer that combines an equalized feedback signal with the received data,
   a slicer coupled to the summer, wherein the slicer converts the combined signal to a binary signal,
   a retimer coupled to the slicer, wherein the retimer generates recovered equalized data from the binary signal in response to an extracted clock signal, and
   a multiplier coupled to the retimer, wherein the multiplier applies an equalization coefficient to the recovered equalized data to generate the equalized feedback signal, and
   a clock and data recovery circuit coupled to the slicer, wherein the clock and data recovery circuit generates the extracted clock signal from the binary signal.

Advantageously, the clock and data recovery circuit comprises a frequency acquisition loop and a phase lock loop, wherein the frequency acquisition loop adjusts frequency of the extracted clock signal to maintain a fixed relationship between frequency of the binary signal and the frequency of the extracted clock signal and wherein the phase lock loop adjusts phase of the extracted clock signal to maintain a fixed relationship between phase of the binary signal and the phase of the extracted clock signal.

Advantageously, the clock and data recovery circuit further comprises a frequency lock detector for determining when the frequency of the extracted clock signal is fixed relative to the frequency of the binary signal.

Advantageously, the multiplier applies a predetermined equalization coefficient upon start up.

According to an example, a method of reducing channel related distortion in received data is provided comprising:
providing received data to a decision feedback equalizer;
generating, by the decision feedback equalizer, a binary signal according to the received data;
extracting a clock signal from the binary signal; and
retiming the binary signal according to the clock signal.

Advantageously, the method further comprises:
maintaining a fixed frequency relationship between the binary signal and the extracted clock signal by adjusting the frequency of the extracted clock signal; and
maintaining a fixed phase relationship between the binary signal and the extracted clock signal by adjusting the phase of the extracted clock signal.

Advantageously, the fixed phase relationship is maintained after determining that the frequency of the extracted clock signal is fixed relative to the frequency of the binary signal.

Advantageously, the method further comprises applying at least one predetermined equalization coefficient to the decision feedback equalizer upon startup.

Advantageously, the method further comprises modifying at least one equalization coefficient to synchronize frequencies of the extracted clock signal and the binary signal.

Advantageously, the method further comprises adjusting at least one equalization coefficient to reduce inter-symbol interference after synchronizing the frequencies of the extracted clock signal and the binary signal.

### BRIEF DESCRIPTION OF THE DRAWINGS

These and other features, aspects, and advantages of the present invention will become better understood with regard to the following description, appended claims, and accompanying drawings, in which:
FIG. 1 is a simplified block diagram of one embodiment of a clock and data recovery circuit;
FIG. 2 is a simplified block diagram of one embodiment of a decision feedback equalizer;
FIG. 3 is a simplified block diagram of one embodiment of an integrated decision feedback equalizer and clock and data recovery circuit;
FIG. 4 is a simplified block diagram of an integrated decision feedback equalizer and a clock and data recovery circuit in accordance with an exemplary embodiment of the present invention;
FIG. 5 is a simplified block diagram of a clock and data recovery circuit with a frequency lock detector in accordance with an exemplary embodiment of the present invention;
FIG. 6 is a simplified circuit diagram of a buffer for driving the clock and data recovery circuit of FIG. 1; and
FIG. 7 is a simplified block diagram of one embodiment of an optical communication system.

In accordance with common practice the various features illustrated in the drawings are not to scale. On the contrary, the dimensions of the various features are arbitrarily expanded or reduced for clarity. In addition like reference numerals denote like features throughout the specification and figures.

### DETAILED DESCRIPTION

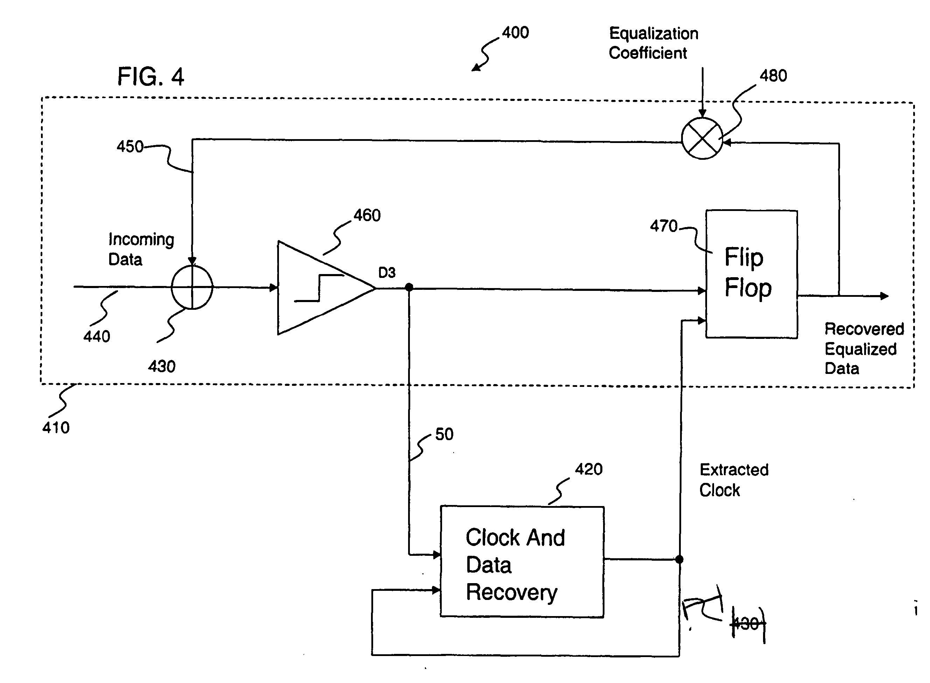

Some embodiments of the present invention provide a high speed receiver with clock and data recovery and decision feedback equalization. Referring to FIG. 4, in one embodiment a one tap decision feedback equalizer 410 is combined with a clock and data recovery circuit 420 to provide a high performance receiver 400. In this embodiment summer 430 combines the incoming data 440 with an equalized feedback signal 450. A slicer 460 converts the output of the summer (soft decision) to a binary signal (D3).

In this embodiment, the binary signal output by the slicer 460 directly drives the data input of flip flop 470 as well as the clock and data recovery circuit 420. The clock and data recovery circuit 420 therefore generates an extracted clock signal from the binary signal (D3) output by the slicer rather than from the incoming data 440 as is done in conventional receivers (see FIG. 3). The extracted clock output by the clock and data recovery circuit 420 is then used to clock the decision feedback equalizer flip flop 470 that recovers the data from the binary signal (D3) in response to the extracted clock.

The clock and data recovery circuit 420 may automatically align the rising edge of the extracted clock, for example, with transitions in the binary signal (D3) output by the slicer 460. Therefore, the illustrated embodiment may maintain the proper timing relationship between the flip flop 470 drive data (D3) and clock (i.e. the extracted clock) to ensure proper data recovery without the need for additional delay matching stages. The elimination of high speed delay matching circuits reduces the power consumption and die area of the receiver.

In the illustrated embodiment a multiplier 480 scales the recovered equalized data output by the flip flop 470 by an equalization coefficient (g1) to generate the equalized feedback signal 450. The value of the equalization coefficient depends on the level of inter-symbol interference that is present in the incoming data. Typically the absolute value of the equalization coefficient (usually a negative number) increases with increasing inter-symbol interference. In one embodiment a real time optimization loop (not shown), such as a least mean square optimization loop, monitors the bit error rate of the incoming signal and adjusts the value of the equalization coefficient in response to changes in the bit error rate.

Summer 430 then combines the equalized feedback signal 450 (typically a negative number) with the incoming data 440. The summer therefore subtracts a scaled version of the previous symbol from a current symbol to reduce or eliminate channel induced distortion such as inter-symbol interference. Therefore, in this embodiment, equalized data (i.e. data that has been processed to remove inter-symbol interference) drives the clock and data recovery circuit 420. As a result, the clock and data recovery circuit 420 more readily locks onto the binary signal (D3) as compared to a receiver that locks onto the incoming data.

Thus, the illustrated embodiment of the present invention may have increased tolerance to inter-symbol interference as compared to conventional receivers because the equalizer 410 compensates for the interference prior to driving the clock and data recovery circuit 420. In addition, in one embodiment the equalization coefficient (g1) is set at a value that is approximately equal to one-half of it's maximum value at startup to ensure that the clock and data recovery circuit 420 locks onto the transitions in the equalized data even in the presence of high inter-symbol interference at start-up.

In this embodiment, a frequency lock detector (not shown) determines whether the clock and data recovery circuit has locked onto the frequency of the equalized data. If not, the equalization coefficient is automatically iterated until the clock and data recovery circuit 420 synchronizes with the frequency of the equalized data at which point a real time optimization loop (not shown) adjusts the equalization coefficient to reduce or minimize the inter-symbol interference in the equalized data.

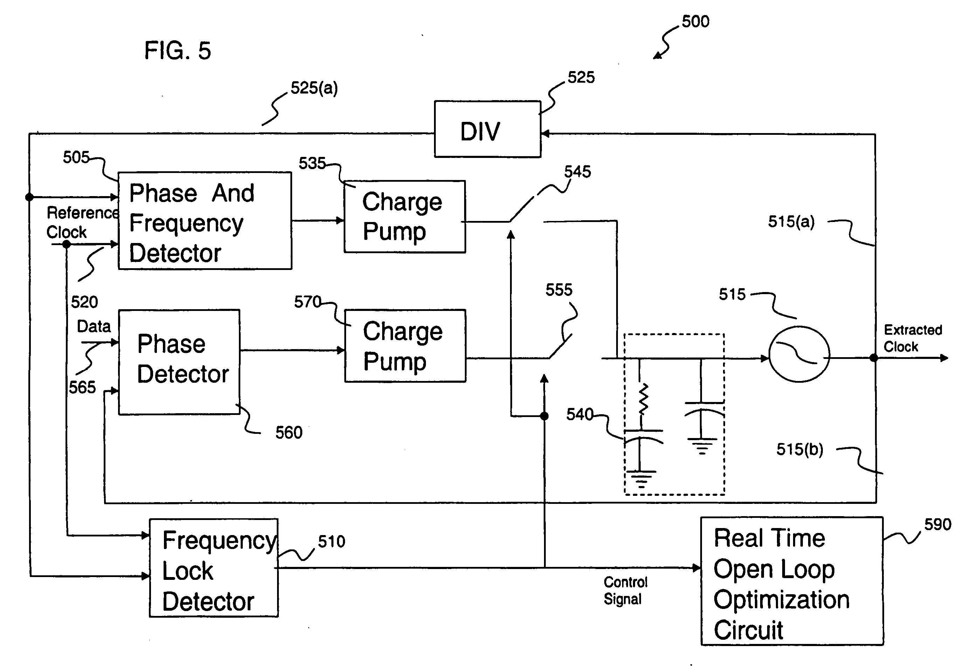

For example, FIG. 5 is a simplified block diagram of a conventional clock and data recovery circuit 500 integrated with a frequency lock detector 510 for generating an extracted clock signal and controlling a real time open loop optimization circuit 590 that generates the equalization coefficient (g1) of the decision feedback equalizer of FIG. 4. In the illustrated embodiment the clock and data recovery circuit includes a frequency acquisition loop and a phase lock loop. The phase lock loop may operate concurrently or sequentially with the frequency acquisition loop.

In one embodiment, for example, the frequency acquisition loop may first tune the output signal of a voltage controlled oscillator 515 to approximately the desired frequency before the phase lock loop is activated. After frequency acquisition the phase lock loop adjusts the phase of the extracted clock to maintain a fixed relationship between the phase of the incoming data signal (e.g. the binary signal (D3) of FIG. 4) and the extracted clock signal.

For example, at start up, a phase and frequency detector 505 determines the frequency difference between a fixed reference clock 520 and a feedback signal 515(a) generated by the voltage controlled oscillator 515. In one embodiment the reference clock 520 is, by way of example, a relatively low-frequency signal generated by a stable oscillation source (e.g., a crystal). In one embodiment, the feedback signal 515(a) output by the voltage controlled oscillator 515 may be divided down in frequency by, for example, a divider 525. The phase and frequency detector 505 then compares the frequency of the divided signal 525(a) with the frequency of the reference clock 520.

In this embodiment the phase and frequency detector 505 generates an output signal that corresponds to the frequency difference between the reference clock 520 and the divided signal 525(a). A charge pump 535 then generates a current signal whose magnitude varies as a function of the magnitude of the output signal of the phase and frequency detector 505. A loop filter 540 then filters out the high frequency components of the current signal output by charge pump 535 and forwards the filtered signal to the voltage controlled oscillator 515.

In this embodiment, if the reference clock leads the divided feedback signal 525(a) output by divider 525, the frequency of the feedback signal 515(a) output by the voltage controller oscillator 515 is less than the frequency of the reference clock 520. In this instance, the charge pump 535 increases its output current to provide a control signal which increases the frequency of the feedback signal 515(a) output by the voltage control oscillator 515.

Similarly, if the reference clock lags the divided feedback signal 525(a) output by divider 525, the frequency of the feedback signal 515(a) output by the voltage controller oscillator 515 is greater than the frequency of the reference clock. In this instance, the charge pump 535 decreases its output current to provide a control signal which decreases the frequency of the feedback signal 515(a) output by the voltage control oscillator 515.

In the illustrated embodiment the output of the voltage controlled oscillator 515 is provided to the frequency detector 505 as a feedback signal. Therefore, the frequency of the feedback signal 515(a) output by the voltage controlled oscillator 515 may be adjusted with greater precision until, for example, a particular threshold condition is satisfied.

For instance, in one embodiment a frequency lock detector 510 determines the relative shift between the frequency of the reference clock 520 and the frequency of the divided signal 525(a). The frequency lock detector 510 then compares this frequency difference to a threshold to determine if the frequency of the feedback signal 515(a) sufficiently matches the frequency of the reference clock.

In one embodiment, the frequency lock detector 510 comprises, by way of example, a pair of counters (not shown) that are reset upon start up. In this embodiment a first counter counts the edges of the reference clock and the second counter counts the transition edges of the divided signal. When one of the counters reaches a predetermined count value the frequency lock detector compares the difference between the count values of each counter to a count threshold. If the count difference is less than the count threshold the reference clock has been acquired.

In this instance, the frequency lock detector 510 outputs a control signal to activate a real time optimization loop 590 that adjusts the equalization coefficient of the decision feedback equalizer of FIG. 4 to reduce inter-symbol interference. In addition, in one embodiment the frequency lock detector 510 opens switch 545 to deactivate the frequency acquisition loop and closes switch 555 to activate the phase lock loop.

The phase lock loop includes a phase detector 560 that receives, by way of example, a data signal 565 (e.g. the binary signal (D3) output by the slicer of FIG. 4) on a first input and the output 515(b) of the voltage control oscillator at a second input. In one embodiment, the phase detector 560 determines a phase relationship between the output 515(b) of the voltage control oscillator 515 and the data signal 565. For example, in one embodiment the phase detector 560 compares transitions in the data signal to the rising edges or the falling edges of the output 515(b) of the voltage control oscillator. The phase detector 560 then produces, by way of example, an error signal that is proportional to the phase relationship.

A charge pump 570 then generates a current signal whose magnitude varies as a function of the magnitude of the output signal of the phase detector 560. The loop filter 540 then filters out the high frequency components of the current signal output by charge pump 570 and forwards the filtered signal to the voltage controlled oscillator 515.

In one embodiment, if the data signal leads the output signal 515(b) of the voltage control oscillator 515, the frequency of the output signal 515(b) of the voltage controller oscillator 515 is less than the frequency of the data signal 565. In this instance, the charge pump 570 increases its output current to provide a control signal which increases the frequency of the output signal 515(b) of the voltage control oscillator 515.

As the frequency of the output signal 515(b) of the voltage control oscillator 515 increases, its edges come sooner in time (i.e., the edges advance in time). Thus, for example, the rising edges of the output signal 515(b) of the voltage control oscillator 515 come in better alignment with the transitions or other reference points in the data signal 565. The feedback may, therefore, insure that the data signal and the output signal 515(b) of the voltage control oscillator 515 have the desired phase relationship for retiming the data via a data retimer (e.g. flip flop 470 of FIG. 4). When the desired phase relationship is reached via the feedback, then the loop may be deemed to be locked.

One of skill in the art will appreciate that the present invention is not limited to a particular clock and data recovery circuit. Rather the present invention is equally applicable to all clock and data recover circuits that generate an extracted clock having a fixed phase and or frequency relationship with a data signal. In addition, although illustrated as separate components, the present invention also contemplates different levels of integration. For example, the phase detector 560 may be integrated, at least in part, with the frequency detector 505. In addition, although many of the signals are illustrated as single-ended signals, the present invention also contemplates that some signals may be differential signals.

In addition, referring back to FIG. 4, one of skill in the art will also appreciate that the output of the summer (i.e. the soft decision) could also be used to drive the clock and data recovery circuit to provide a receiver having increased inter-symbol interference tolerance. However, in the receiver illustrated in FIG. 4, the slicer 460 effectively amplifies the incoming data to a suitable level to drive the clock and data recovery circuit 420. The illustrated embodiment therefore allows for the elimination of the buffer stages that are typically used to amplify the incoming data prior to clock recovery in a conventional receiver system. The illustrated integration of the decision feedback equalizer 410 and clock and data recovery circuit 420 reduces the cost and power consumption of receiver 400 as compared to conventional systems.

For example, in high speed applications the elimination of the high speed buffer stage(s) for the clock and data recovery circuit can significantly reduce the cost and the die size of the receiver. More specifically, high speed receiver components fabricated from a complementary metal oxide semiconductor (CMOS) process may include shunt peaking inductive loads to improve the bandwidth of the component.

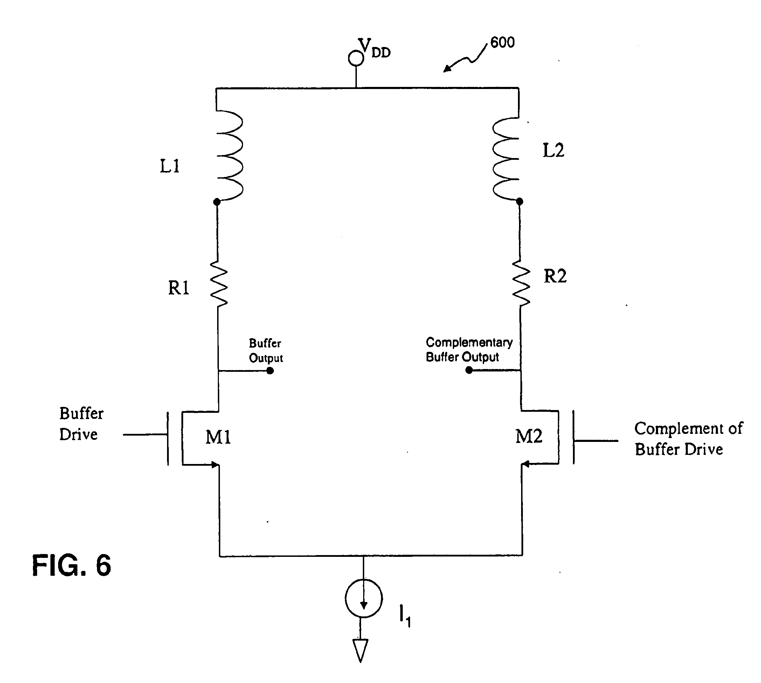

For instance, FIG. 6 is a simplified circuit diagram of a single stage high speed buffer 600 for driving the clock and data recovery circuit of FIG. 1. In this embodiment, a differential pair of inductively loaded NMOS FETs M1 and M2 are coupled between a positive voltage source V_{DD} and a bias current source I₁. Advantageously, the use of inductive loads L₁ and L₂ tunes out the parasitic capacitive loading on the inputs of the buffer and increases the bandwidth of the device.

However, the spiral inductors L₁ and L₂ are relatively large devices that consume considerable die area driving up the relative cost and size of the receiver. In addition, the large spiral conductors also increase the length of the interconnects between stages in a multi-stage buffer, thereby increasing the parasitic capacitive loading between stages. The increased capacitance increases power consumption and decreases the bandwidth of the device.

In addition high speed devices tend to consume considerable power as compared to low speed devices. Therefore, the elimination of the buffer stage(s) which typically drive the input of the clock and data recovery circuit of conventional receivers provides significant advantages in terms of cost, size and power consumption.

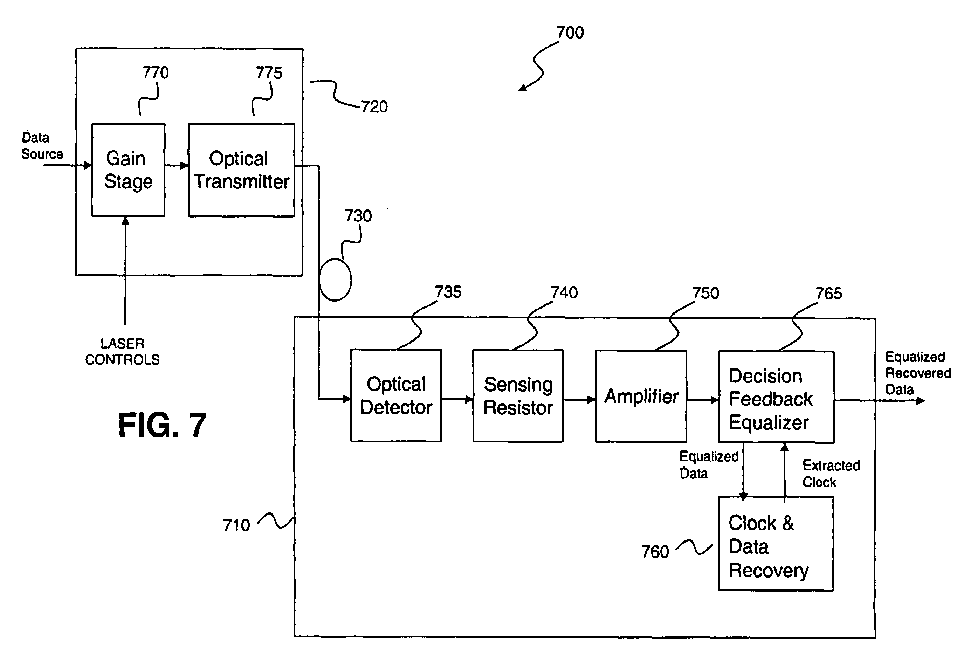

The integrated decision feedback equalizer and clock and data recovery circuit illustrated in FIG. 4 may be integrated into any of a variety of applications. For example, referring to FIG. 7, the described exemplary integrated decision feedback equalizer and clock and data recovery circuit may be incorporated into the optical receiver assembly 710 of an optical communication system 700. The optical system 700 includes an optical transmitter 720 and an optical fiber network 730 that carries the optical signal to the optical receiver assembly 710. Those skilled in the art will appreciate that the present invention is not limited to a single optical transmitter and receiver. Rather practical optical communications systems may have one or more optical transmitters as well as one or more optical receivers.

The illustrated receive path includes an optical detector 735, sensing resistor 740, one or more amplifiers 750, clock and data recovery circuit 760, and decision feedback equalizer 765. The optical detector 735 can be any known prior art optical detector. Such prior art detectors convert incoming optical signals into corresponding electrical output signals that can be electronically monitored.

A transmit path includes, by way of example, one or more gain stage(s) 770 coupled to an optical transmitter 775. In one embodiment an analog data source provides an analog data signal that modulates the output of the optical transmitter. In other embodiments baseband digital modulation or frequency modulation may be used. In this embodiment the gain stage(s) amplify the incoming data signal and the amplified data signal in turn drives the optical transmitter 775.

The gain stage 770 may have multiple stages, and may receive one or more control signals for controlling various different parameters of the output of the optical transmitter. The optical transmitter may, for example, be a light emitting diode or a surface emitting laser or an edge emitting laser that operates at high speeds such as 10 Gigabits per second (Gbps) or higher.

A receive fiber optic cable 730 carries an optical data signal to the optical detector 735. In operation, when the transmitted optical beam is incident on a light receiving surface area of the optical detector, electron-hole pairs are generated. A bias voltage applied across the device generates a flow of electric current having an intensity proportional to the intensity of the incident light. In one embodiment, this current flows through sensing resistor 740, and generates a voltage.

The sensed voltage is amplified by the one or more amplifiers 750 and the output of amplifier 750 drives the decision feedback equalizer 765. As illustrated in FIG, 4, the decision feedback equalizer, includes, by way of example, a slicer that generates a binary signal (D3) that drives the clock and data recovery circuit 760. The clock and data recovery circuit generates an extracted clock signal from the binary signal which is coupled to a decision feedback equalizer retimer (as illustrated in FIG. 4) to retime the equalized data.

It will be appreciated by those of ordinary skill in the art that the invention can be embodied in other specific forms without departing from the scope of the claims. For example, the teachings herein may be applied to different types of receivers, decision feedback equalizers and clock and data recovery circuits. The present invention is therefore considered in all respects to be illustrative and not restrictive. The scope of the invention is indicated by the appended claims, and all changes that come within the meaning and range of equivalents thereof are intended to be embraced therein.

## Claims

1. A communications system (400) comprising:
a decision feedback equalizer(410) adapted to reduce channel related distortion in received data (440), wherein the decision feedback equalizer(410) is adapted to generate equalized data; and
a clock and data recovery circuit (420) coupled to the decision feedback equalizer (410), wherein the clock and data recovery circuit (420) is adapted to generate an extracted clock signal from the equalized data , wherein the decision feedback equalizer(410) includes a retimer (470) that is adapted to generate recovered equalized data from the equalized data in response to the extracted clock signals ;
a multiplier (480) coupled to the retimer, wherein the multiplier (480) is adapted to apply an equalization coefficient to the recovered equalized data to generate an equalized feedback signal (450);
a summer (430) adapted to combine the equalized feedback signal (450) and the received data (440) to generate a combined signal as basis for the equalized data;
a frequency lock detector (510) adapted to determine whether the clock and data recovery circuit (420) has locked onto the frequency of the equalized data; and
a means for automatically iterating the value of the equalization coefficient until the clock and data recovery circuit (420) synchronizes with the frequency of the equalized data.

2. The communications system (400) of claim 1 further comprising:
a real time optimization loop adapted to monitor a bit error rate of the received data and adjust the value of the equalization coefficient in response to changes in the bit error rate.

3. The communications system (400) of claim 2 wherein the real time optimization loop is adapted to adjust the equalization coefficient to minimize the inter-symbol interference in the equalized data after the frequency lock detector has determined that the clock and data recovery circuit (420) has locked onto the frequency of the equalized data.

4. The communications system (400) of claim 1 wherein the decision feedback equalizer (410) comprises the summer (430) that is adapted to generate the combined signal by combining the equalized feedback signal (450) with the received data (440) to reduce the channel related distortion.

5. The communications system (400) of claim4 wherein, at the start-up of the communications system (400), the equalization coefficient is set at a value that is substantially equal to -0.5 times the amplitude of the received data.

6. The communications system (400) of claim 4 wherein the decision feedback equalizer(410) further comprises a slicer(460) coupled to the summer (430), wherein the slicer(460) is adapted to generate the equalized data by converting the combined signal into a binary signal and wherein the clock and data recovery circuit (420) is adapted to generate the extracted clock signal from the binary signal.

7. The communications system (400) of claim 6 wherein the retimer comprises a flip flop(470) coupled to the slicer(460) and the clock and data recovery circuit (420) and wherein the flip flop(470) is adapted to generate the recovered equalized data from the binary signal in response to the extracted clock signal.

8. An extended communication system comprising:
a transmitter for transmitting an information signal over a communication media; and
a receiver coupled to the communication media for receiving the transmitted information signal, wherein the receiver comprises the communication system (400) of claim 1.

9. The extended communications system of claim 8 wherein the decision feedback equalizer(410) comprises the summer (430) that is adapted to generate the combined signal by combining the equalized feedback signal(450) with the received data (440) to reduce the channel related distortion.

10. An extended communications system comprising the communications system (400) of claim 1, wherein the decision feedback equalizer (410) further comprises:
a slicer(460) coupled to the summer (430), wherein the slicer(460) is adapted to convert the combined signal to a binary signal,
wherein the retimer and the clock and data recovery circuit (420) are coupled to the slicer (460).

11. The extended communications system of claim 10 wherein the clock and data recovery circuit (420) comprises a frequency acquisition loop and a phase lock loop, wherein the frequency acquisition loop is adapted to adjust frequency of the extracted clock signal to maintain a fixed relationship between frequency of the binary signal and the frequency of the extracted clock signal and wherein the phase lock loop is adapted to adjust phase of the extracted clock signal to maintain a fixed relationship between phase of the binary signal and the phase of the extracted clock signal.

12. A method of reducing channel related distortion in received data comprising:
providing received data (440) to a decision feedback equalizer(410);
generating, by the decision feedback equalizer, (410), equalized data according to the received data (440);
extracting, by a clock and data recovery circuit (420), a clock signal from the equalized data;
retiming the equalized data according to the clock signal.
applying an equalization coefficient to the recovered equalized data to generate an equalized feedback signal (450);
combining the equalized feedback signal(450) and the received data (440) to generate a combined signal as basis for the equalized data;
determining whether the clock and data recovery circuit (420) has locked onto the frequency of the equalized data by a frequency lock detector (510); and
automatically iterating the value of the equalization coefficient until the clock and data recovery circuit (420) synchronizes with the frequency of the equalized data.

13. The method of claim 12 further comprising:
maintaining a fixed frequency relationship between the equalized data and the extracted clock signal by adjusting the frequency of the extracted clock signal; and
maintaining a fixed phase relationship between the equalized data and the extracted clock signal by adjusting the phase of the extracted clock signal.

## Patentansprüche

1. Kommunikationssystem (400), das umfasst:
- einen Entzerrer mit Entscheidungsrückführung (410), der dafür ausgelegt ist, die kanalbedingte Verzerrung in empfangenen Daten (440) zu reduzieren, wobei der Entzerrer mit Entscheidungsrückführung (410) dafür ausgelegt ist, entzerrte Daten zu generieren, und
- eine Takt- und Datenrückgewinnungsschaltung (420), die mit dem Entzerrer mit Entscheidungsrückführung (410) gekoppelt ist, wobei die Takt- und Datenrückgewinnungsschaltung (420) dafür ausgelegt ist, aus den entzerrten Daten ein extrahiertes Taktsignal zu generieren,
- wobei der Entzerrer mit Entscheidungsrückführung (410) umfasst:
- einen Retimer (470), der dafür ausgelegt ist, in Antwort auf das extrahierte Taktsignal aus den entzerrten Daten zurückgewonnene entzerrte Daten zu generieren,
- einen Multiplizierer (480), der mit dem Retimer gekoppelt ist, wobei der Multiplizierer (480) dafür ausgelegt ist, auf die zurückgewonnenen entzerrten Daten einen Entzerrungskoeffizienten anzuwenden, um ein entzerrtes Rückführungssignal (450) zu generieren,
- einen Summierer (430), der dafür ausgelegt ist, das entzerrte Rückführungssignal (450) und die empfangenen Daten (440) zu kombinieren, um ein kombiniertes Signal als Basis für die entzerrten Daten zu generieren,
- einen Frequenzsynchronisationsdetektor (510), der dafür ausgelegt ist, zu bestimmen, ob die Takt- und Datenrückgewinnungsschaltung (420) mit der Frequenz der entzerrten Daten synchronisiert ist, und
- eine Einrichtung zum automatischen Iterieren des Wertes des Entzerrungskoeffizienten bis die Takt- und Datenrückgewinnungsschaltung (420) mit der Frequenz der entzerrten Daten synchronisiert ist.

2. Kommunikationssystem (400) nach Anspruch 1,
das ferner umfasst:
- eine Echtzeit-Optimierungsschleife, die dafür ausgelegt ist, eine Bitfehlerrate der empfangenen Daten zu überwachen und den Wert des Entzerrungskoeffizienten in Antwort auf Veränderungen der Bitfehlerrate anzupassen.

3. Kommunikationssystem (400) nach Anspruch 2,
wobei die Echtzeit-Optimierungsschleife dafür ausgelegt ist, den Entzerrungskoeffizienten anzupassen, um die Intersymbolinterferenz in den entzerrten Daten zu minimieren, nachdem der Frequenzsynchronisationsdetektor bestimmt hat, dass die Takt- und Datenrückgewinnungsschaltung (420) mit der Frequenz der entzerrten Daten synchronisiert ist.

4. Kommunikationssystem (400) nach Anspruch 1,
wobei der Entzerrer mit Entscheidungsrückführung (410) den Summierer (430) umfasst, der dafür ausgelegt ist, durch Kombinieren des entzerrten Rückführungssignals (450) mit den empfangenen Daten (440) das kombinierte Signal zu generieren, um die kanalbedingte Verzerrung zu reduzieren.

5. Kommunikationssystem (400) nach Anspruch 4,
wobei der Entzerrungskoeffizient in der Anlaufphase des Kommunikationssystems (400) auf einen Wert gesetzt wird, der im Wesentlichen dem -0,5-fachen der Amplitude der empfangenen Daten entspricht.

6. Kommunikationssystem (400) nach Anspruch 4,
wobei der Entzerrer mit Entscheidungsrückführung (410) ferner einen Slicer (Abtrennschaltung) (460) umfasst, der mit dem Summierer (430) gekoppelt ist, wobei der Slicer (460) dafür ausgelegt ist, durch Konvertieren des kombinierten Signals in ein binäres Signal die entzerrten Daten zu generieren, und wobei die Takt- und Datenrückgewinnungsschaltung (420) dafür ausgelegt ist, das extrahierte Taktsignal aus dem binären Signal zu generieren.

7. Kommunikationssystem (400) nach Anspruch 6,
wobei der Retimer ein Flipflop (470) umfasst, das mit dem Slicer (460) und der Taktund Datenrückgewinnungsschaltung (420) gekoppelt ist, und wobei das Flipflop (470) dafür ausgelegt ist, in Antwort auf das extrahierte Taktsignal aus dem binären Signal die zurückgewonnenen entzerrten Daten zu generieren.

8. Erweitertes Kommunikationssystem, das umfasst:
- einen Sender zum Senden eines Informationssignals über ein Kommunikationsmedium, und
- einen Empfänger, der mit dem Kommunikationsmedium gekoppelt ist, um das gesendete Informationssignal zu empfangen, wobei der Empfänger das Kommunikationssystem (400) nach Anspruch 1 umfasst.

9. Erweitertes Kommunikationssystem nach Anspruch 8,
wobei der Entzerrer mit Entscheidungsrückführung (410) den Summierer (430) umfasst, der dafür ausgelegt ist, durch Kombinieren des entzerrten Rückführungssignals (450) mit den empfangenen Daten (440) das kombinierte Signal zu generieren, um die kanalbedingte Verzerrung zu reduzieren.

10. Erweitertes Kommunikationssystem, das das Kommunikationssystem (400) nach Anspruch 1 umfasst, wobei der Entzerrer mit Entscheidungsrückführung (410) ferner umfasst:
- einen Slicer (460), der mit dem Summierer (430) gekoppelt ist, wobei der Slicer (460) dafür ausgelegt ist, das kombinierte Signal in ein binäres Signal zu konvertieren,
- wobei der Retimer und die Takt- und Datenrückgewinnungsschaltung (420) mit dem Slicer (460) gekoppelt sind.

11. Erweitertes Kommunikationssystem nach Anspruch 10,
wobei die Takt- und Datenrückgewinnungsschaltung (420) eine Frequenzerfassungsschleife und einen Phasenregelkreis umfasst, wobei die Frequenzerfassungsschleife dafür ausgelegt ist, die Frequenz des extrahierten Taktsignals anzupassen, um zwischen der Frequenz des binären Signals und der Frequenz des extrahierten Taktsignals ein festes Verhältnis aufrechtzuerhalten, und wobei der Phasenregelkreis dafür ausgelegt ist, die Phase des extrahierten Taktsignals anzupassen, um zwischen der Phase des binären Signals und der Phase des extrahierten Taktsignals ein festes Verhältnis aufrechtzuerhalten.

12. Verfahren zum Reduzieren kanalbedingter Verzerrung in empfangenen Daten, das umfasst:
- Zuführen empfangener Daten (440) zu einem Entzerrer mit Entscheidungsrückführung (410),
- Generieren den empfangenen Daten (440) entsprechender entzerrter Daten durch den Entzerrer mit Entscheidungsrückführung (410),
- Extrahieren eines Taktsignals aus den entzerrten Daten durch eine Takt- und Datenrückgewinnungsschaltung (420),
- Retiming (zeitliches Regenerieren) der entzerrten Daten entsprechend dem Taktsignal,
- Anwenden eines Entzerrungskoeffizienten auf die zurückgewonnenen entzerrten Daten, um ein entzerrtes Rückführungssignal (450) zu generieren,
- Kombinieren des entzerrten Rückführungssignals (450) mit den empfangenen Daten (440), um ein kombiniertes Signal als Basis für die entzerrten Daten zu generieren,
- Bestimmen, durch einen Frequenzsynchronisationsdetektor (510), ob die Takt- und Datenrückgewinnungsschaltung (420) mit der Frequenz der entzerrten Daten synchronisiert ist, und
- automatisches Iterieren des Wertes des Entzerrungskoeffizienten bis die Taktund Datenrückgewinnungsschaltung (420) mit der Frequenz der entzerrten Daten synchronisiert ist.

13. Verfahren nach Anspruch 12,
das ferner umfasst:
- Aufrechterhalten eines festen Frequenzverhältnisses zwischen den entzerrten Daten und dem extrahierten Taktsignal durch Anpassen der Frequenz des extrahierten Taktsignals, und
- Aufrechterhalten eines festen Phasenverhältnisses zwischen den entzerrten Daten und dem extrahierten Taktsignal durch Anpassen der Phase des extrahierten Taktsignals.

## Revendications

1. Système de communications (400) comprenant :
un égaliseur de retour d'information de décision (410) adapté à réduire une distorsion se rapportant à un canal dans des données reçues (440), dans lequel l'égaliseur de retour d'information de décision (410) est adapté à générer des données égalisées ; et
un circuit de récupération d'horloge et de données (420) couplé à l'égaliseur de retour d'information de décision (410), dans lequel le circuit de récupération d'horloge et de données (420) est adapté à générer un signal d'horloge extrait à partir des données égalisées,
dans lequel l'égaliseur de retour d'information de décision (410) inclut :
un réajusteur du rythme (470) qui est adapté à générer des données égalisées récupérées à partir des données égalisées en réponse au signal d'horloge extrait ;
un multiplicateur (480) couplé au réajusteur du rythme, dans lequel le multiplicateur (480) est adapté à appliquer un coefficient d'égalisation aux données égalisées récupérées pour générer un signal de retour d'information égalisé (450) ;
un sommateur (430) adapté à combiner le signal de retour d'information égalisé (450) et les données reçues (440) pour générer un signal combiné comme base pour les données égalisées ;
un détecteur de verrouillage de fréquence (510) adapté à déterminer si le circuit de récupération d'horloge et de données (420) s'est verrouillé sur la fréquence des données égalisées ; et
un moyen pour automatiquement itérer la valeur du coefficient d'égalisation jusqu'à ce que le circuit de récupération d'horloge et de données (420) se synchronise avec la fréquence des données égalisées.

2. Système de communications (400) selon la revendication 1 comprenant en outre :
une boucle d'optimisation en temps réel adaptée à surveiller un taux d'erreurs sur les bits des données reçues et ajuster la valeur du coefficient d'égalisation en réponse à des changements dans le taux d'erreurs sur les bits.

3. Système de communications (400) selon la revendication 2, dans lequel la boucle d'optimisation en temps réel est adaptée à ajuster le coefficient d'égalisation pour minimiser l'interférence inter-symboles dans les données égalisées après que le détecteur de verrouillage de fréquence a déterminé que le circuit de récupération d'horloge et de données (420) s'est verrouillé sur la fréquence des données égalisées.

4. Système de communications (400) selon la revendication 1, dans lequel l'égaliseur de retour d'information de décision (410) comprend le sommateur (430) qui est adapté à générer le signal combiné en combinant le signal de retour d'information égalisé (450) avec les données reçues (440) pour réduire la distorsion se rapportant au canal.

5. Système de communications (400) selon la revendication 4, dans lequel, au démarrage du système de communications (400), le coefficient d'égalisation est fixé à une valeur qui est sensiblement égale à -0,5 fois l'amplitude des données reçues.

6. Système de communications (400) selon la revendication 4, dans lequel l'égaliseur de retour d'information de décision (410) comprend en outre un filtre limiteur (460) couplé au sommateur (430), dans lequel le filtre limiteur (460) est adapté à générer les données égalisées en convertissant le signal combiné en un signal binaire et dans lequel le circuit de récupération d'horloge et de données (420) est adapté à générer le signal d'horloge extrait à partir du signal binaire.

7. Système de communications (400) selon la revendication 6, dans lequel le réajusteur du rythme comprend une bascule bistable (470) couplée au filtre limiteur (460) et au circuit de récupération d'horloge et de données (420) et dans lequel la bascule bistable (470) est adaptée à générer les données égalisées récupérées à partir du signal binaire en réponse au signal d'horloge extrait.

8. Système de communications étendu comprenant :
un émetteur pour émettre un signal d'information sur un support de communication ; et
un récepteur couplé au support de communication pour recevoir le signal d'information émis, dans lequel le récepteur comprend le système de communications (400) selon la revendication 1.

9. Système de communications étendu selon la revendication 8, dans lequel l'égaliseur de retour d'information de décision (410) comprend le sommateur (430) qui est adapté à générer le signal combiné en combinant le signal de retour d'information égalisé (450) avec les données reçues (440) pour réduire la distorsion se rapportant au canal.

10. Système de communications étendu comprenant le système de communications (400) selon la revendication 1, dans lequel l'égaliseur de retour d'information de décision (410) comprend en outre :
un filtre limiteur (460) couplé au sommateur (430), dans lequel le filtre limiteur (460) est adapté à convertir le signal combiné en un signal binaire,
dans lequel le réajusteur du rythme et le circuit de récupération d'horloge et de données (420) sont couplés au filtre limiteur (460).

11. Système de communications étendu selon la revendication 10, dans lequel le circuit de récupération d'horloge et de données (420) comprend une boucle d'acquisition de fréquence et une boucle à verrouillage de phase, dans lequel la boucle d'acquisition de fréquence est adaptée à ajuster la fréquence du signal d'horloge extrait pour maintenir une relation fixe entre une fréquence du signal binaire et la fréquence du signal d'horloge extrait et dans lequel la boucle à verrouillage de phase est adaptée à ajuster une phase du signal d'horloge extrait pour maintenir une relation fixe entre une phase du signal binaire et la phase du signal d'horloge extrait.

12. Procédé de réduction d'une distorsion se rapportant au canal dans des données reçues comprenant :
la délivrance de données reçues (440) à un égaliseur de retour d'information de décision (410) ;
la génération, par l'égaliseur de retour d'information de décision (410), de données égalisées en fonction des données reçues (440) ;
l'extraction, par un circuit de récupération d'horloge et de données (420), d'un signal d'horloge à partir des données égalisées ;
le réajustement du rythme des données égalisées en fonction du signal d'horloge ;
l'application d'un coefficient d'égalisation aux données égalisées récupérées pour générer un signal de retour d'information égalisé (450) ;
la combinaison du signal de retour d'information égalisé (450) et des données reçues (440) pour générer un signal combiné comme base pour les données égalisées ;
la détermination si le circuit de récupération d'horloge et de données (420) s'est verrouillé sur la fréquence des données égalisées par un détecteur de verrouillage de fréquence (510) ; et
l'itération automatique de la valeur du coefficient d'égalisation jusqu'à ce que le circuit de récupération d'horloge et de données (420) se synchronise avec la fréquence des données égalisées.

13. Procédé selon la revendication 12 comprenant en outre :
le maintien d'une relation de fréquence fixe entre les données égalisées et le signal d'horloge extrait en ajustant la fréquence du signal d'horloge extrait ; et
le maintien d'une relation de phase fixe entre les données égalisées et le signal d'horloge extrait en ajustant la phase du signal d'horloge extrait.
